Europäisches Patentamt

European Patent Office

Office européen des brevets

(19)

(11) Numéro de publication: **0 001 375**
**B1**

(12) **FASCICULE DE BREVET EUROPEEN**

(45) Date de publication du fascicule de brevet:
01.04.81

(51) Int. Cl.³: **H 01 L 27/15**

(21) Numéro de dépôt: **78430012.1**

(22) Date de dépôt: **25.08.78**

(54) **Agencement de diodes luminescentes multicolores intégrées dans un corps semi-conducteur et son procédé de fabrication.**

(30) Priorité: **21.09.77 US 835098**

(43) Date de publication de la demande:
**04.04.79 Bulletin 79/7**

(45) Mention de la délivrance du brevet:
**01.04.81 Bulletin 81/13**

(84) Etats contractants désignés:
**DE FR GB**

(56) Documents cités:
**FR-A-2 317 774**
**US-A-3 890 170**
**US-A-3 947 840**

**IBM TECHNICAL DISCLOSURE BULLETIN**
**vol. 12, n° 10, mars 1970;**
**New York**
**J.M. WOODALL: "Optical communications link"**
**pages 1584–1585.**

**JOURNAL OF APPLIED PHYSICS,**
**vol. 48, n° 1, janvier 1977,**
**New York**
**M. KITADA: "Upside-down fabricated GaP monolithic display"**
**pages 279–281**

(73) Titulaire: **International Business Machines Corporation, Armonk, N.Y. 10504 (US)**

(72) Inventeur: **Hung, Roland Yen-Mou, RFD Green Tree Road, Yorktown Heights New York 10598 (US)**
Inventeur: *Shih, Kwang Kuo, 2322 Vista Court, Yorktown Heights New York 10598 (US)*

(74) Mandataire: **Klein, Daniel, COMPAGNIE IBM FRANCE Département de Propriété Industrielle, F-06610 La Gaude (FR)**

Agencement de diodes luminescentes multicolores intégrées dans un corps semi-conducteur et son procédé
de fabrication

## Domaine technique

La présente invention concerne un agencement de diodes luminescentes multicolores intégrées dans un corps semi-conducteur et plus particulièrement un agencement qui soit approprié à la technologie de formation de contacts par reflux de soudure. Elle concerne également son procédé de fabrication.

## Etat de la technique antérieure

Des agencements de diodes luminescentes multicolores sont connus dans la technique, on pourra se référer par exemple à la demande de brevet français No. 75 21402 déposée le 8 juillet 1975 par R.T.C. La Radiotechnique et publiée sous le No. 2317774 et à l'article «Optical Communications Link» publié dans l'IBM Technical Disclosure Bulletin Vol. 12, No. 10, mars 1970, page 1584.

Dans le brevet précité, il est montré une structure multicouches, avec des couches actives de compositions différentes séparées par des couches d'accrochage. Les jonctions sont réalisées dans les couches actives. Cette structure apparaît donc fort complexe dès lors que l'on veut intégrer un nombre important de diodes émettant dans des gammes différentes.

La publication précitée montre un procédé de fabrication de diodes luminescentes multicolores intégrées dans un substrat, en décapant en biseau une couche épitaxiale de type N de composition variable (par exemple $Ga_{1-x}Al_xAs$, avec x variant entre certaines limites), en formant une couche de type P par diffusion de zinc dans la couche épitaxiale, et enfin en isolant les différentes diodes ainsi crées.

L'emploi de diodes luminescentes s'est généralisé depuis quelques années car ces dispositifs constituent un moyen très efficace pour effectuer une conversion d'énergie électrique en énergie électromagnétique qui trouve son application dans divers dispositifs d'affichage. Toutefois, des problèmes se posent en ce qui concerne l'établissement de contacts avec ce type de diode car chacune d'elles nécessite une connexion par fil. Par ailleurs, des interférences optiques se produisent dans le cas d'ensembles présentant une densité élevée de telles diodes. Ces problèmes ont jusqu'ici affecté le prix de revient de ces diodes, de même que leur fiabilité et leur densité d'assemblage.

## Exposé de l'invention

Selon la présente invention, des ensembles de diodes luminescentes multicolores peuvent être fabriqués sur un unique corps de manière à permettre d'une part la réalisation de connexions par reflux de soudure et d'autre part l'obtention d'un isolement optique. Ceci est obtenu grâce à l'emploi, dans ce corps, de deux couches dont la première contient des éléments dont la concentration présente un gradient, c'est-à-dire varie graduellement, entre une de ses surfaces et cette seconde couche, de telle sorte que la formation d'une jonction p-n en un point donné produise une lumière d'une couleur spécifique qui peut être choisie. En outre cette seconde couche, lorsqu'elle est partiellement retirée, peut assurer un isolement optique. Enfin des contacts métalliques (faisant partie des moyens de polarisation) établis avec la jonction p-n d'une diode luminescente déterminée permettent de réaliser des connexions par reflux de soudure.

D'autres objets, caractéristiques et avantages de la présente invention ressortiront mieux de l'exposé qui suit, fait en référence aux dessins annexés à ce texte, qui représentent un mode de réalisation préféré de celle-ci.

## Brève description des figures

La fig. 1 représente un corps semi-conducteur qui comporte différentes régions émettrices de lumière.

La fig. 2 représente ce corps semi-conducteur dans lequel les connexions établies par reflux de soudure ainsi que l'isolement optique obtenu, sont mis en évidence.

La fig. 3 représente un second corps semi-conducteur conforme à la présente invention et dans lequel un agencement de diodes luminescentes a été réalisé.

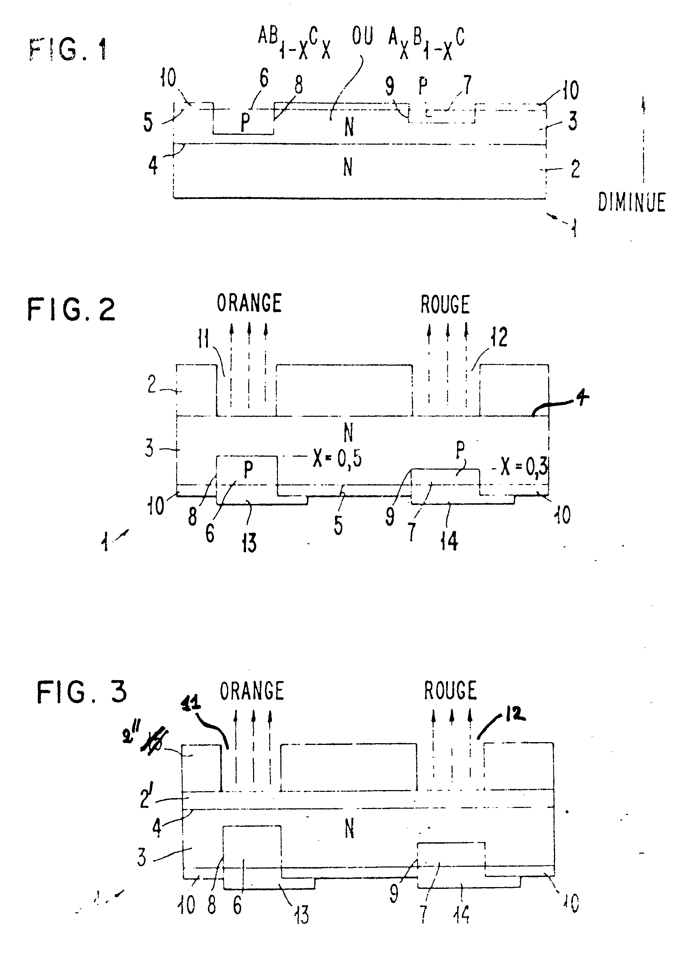

On a représenté sur la fig. 1 un corps semi-conducteur 1 dans lequel un agencement de diodes luminescentes peut être réalisé conformément aux enseignements de la présente invention. Ce corps constitue une structure qui comprend une partie 2 formant substrat, composée d'un matériau de type binaire, et une partie 3 présentant un gradient de concentration composée par exemple, d'un matériau de type ternaire obéissant à la formule générale $A_xB_{1-x}$ C ou $AB_{1-x}$ $C_x$, atomiquement compatible et formant une démarcation 4. La fonction de la partie 2 est de servir de support et de base de croissance épitaxiale, et de présenter en même temps des propriétés optiques permettant d'assurer l'isolement des différents dispositifs. Un agencement présente une meilleure définition optique lorsque les différentes diodes qui le composent, comportent un élément qui dirige la lumière. Le matériau employé, de l'arséniure de gallium, permet de satisfaire à ces exigences. En ce qui concerne la partie 3, le matériau employé doit être un semi-conducteur qui permet d'obtenir une lumière dont la couleur varie en fonction de la concentration des éléments composant les différentes diodes, et qui offre la possibilité de modifier cette concentration. Le matériau $Al_xGa_{1-x}As$ répond à ces exigences. Le gradient est tel que la variable x a sa valeur la plus forte au niveau de sa ligne de démarcation 4, et la valeur la plus faible au niveau de la surface supérieure 5. Dans ce matériau $Al_xGa_{1-x}As$, la concentration d'aluminium initiale est donc la plus faible au niveau de la surface 5 et augmente graduellement au fur et à mesure qu'on se rapproche de la ligne de démarcation 4. La structure 1 représentée sur la fig. 1 comporte des régions de type p 6 et 7 qui ont des profondeurs différentes et qui forment respectivement les jonctions p-n 8 et 9 avec la région de type n 3. Une couche d'oxyde 10 est prévue pour des raisons de masquage et d'isolement.

La fig. 2 montre un agencement de diodes luminescentes intégrées, qui est réalisé conformément à l'invention à partir de l'agencement représenté sur la fig. 1. Comme le montre la fig. 2, la structure 1 a été renversée et des ouvertures 11 et 12 ont été réalisées par décapage dans la partie 2 afin de permettre la sortie de la lumière engendrée par les diodes luminescentes au niveau des jonctions 8 et 9, tout en assurant l'isolement optique de chaque diode. Les jonctions p-n 8 et 9 ont des profondeurs différentes afin qu'une lumière de couleur différente puisse être obtenue en fonction de la valeur de la variable. Dans le cas de la jonction 9, si le matériau constituant la couche 3 est de l'$Al_xGa_{1-x}As$, avec un coefficient x égal à 0,3 de la lumière rouge sera émise au niveau de l'ouverture 12. De même, avec un coefficient x égal à 0,5 une lumière orange sera émise par l'ouverture 11. Des contacts métalliques 13 et 14 sont établis respectivement avec les régions 6 et 7; on laisse ces contacts recouvrir partiellement l'oxyde 10 de telle sorte qu'ils s'étendent sur une surface plus grande que celle des régions 6 et 7. On peut ainsi établir des contacts avec ces régions grâce à l'emploi de la technique bien connue dite du reflux de soudure, dans laquelle une quantité de soudure suffisante est maintenue sur le contact par la tension de surface lors du reflux. Cette technique permet de réaliser toutes les connexions requises avec les diodes au cours d'un unique cycle thermique.

La structure 1 peut être réalisée au moyen de la technique de croissance épitaxiale en phase vapeur ou en phase liquide. Dans ce dernier cas, la région à gradient 3 est formée à partir d'un bain d'un matériau semi-conducteur du type $A_x B_{1-x} C$ en fusion, par exemple de l'arséniure de gallium et d'aluminium $Al_xGa_{1-x}As$. A cette fin, le bain est mis en contact avec le substrat 2, composé de type binaire, par exemple, de l'arséniure de gallium, et le matériau épitaxial se forme à partir du bain en maintenant la périodicité du cristal initial. La concentration dans le bain de l'aluminium et du gallium est réglée de telle sorte qu'elle varie entre la ligne de démarcation 4, où la concentration d'aluminium est la plus élevée (x=1), et la surface supérieure 5, où la concentration est la plus faible (x=0).

Dans le cas de la technique de croissance épitaxiale en phase vapeur, le substrat 2 de type binaire, constitué cette fois, par exemple, par du phosphure de gallium, est exposé à une vapeur contenant le semi-conducteur du type $AB_{1-x}C_x$, dans cet exemple, du $Ga As_{1-x}P_x$, qui forme la région 3, après quoi la réaction chimique qui se produit dans la vapeur se traduit par une croissance qui maintient la périodicité cristalline du substrat et de la concentration dans la vapeur permet de commander la concentration des différents éléments qui composent la région 3. Ces techniques sont bien connues. Les régions 6 et 7 sont réalisées au moyen de techniques classiques de formation de jonction p-n telles que des techniques d'alliage, de diffusion ou d'implantation ionique, dans la mesure où elles permettent d'obtenir la profondeur désirée avec des dopants de type p classiques. Etant donné qu'il est souhaitable de disposer les jonctions p-n 8 et 9 avec une concentration désirée dans la région 3, ces techniques permettront d'obtenir le résultat recherché, ainsi que le comprendra l'homme de l'art.

La fig. 3 représente une structure comportant les mêmes éléments que ceux précédemment décrits, mais dans laquelle le substrat 2 a été poli jusqu'à obtention d'une épaisseur 2' telle que la transparence optique soit acceptable, l'isolation optique étant alors assurée par un matériau 2'', tel que du GaAs, qui n'a pas besoin d'être épitaxial. Cette structure se prête particulièrement bien à l'emploi de la technique de croissance épitaxiale en phase vapeur, dans laquelle, lorsque les matériaux employés sont l'arséniure de gallium et le phosphure de gallium, la vapeur permet de commander plus facilement les concentrations d'arsenic et de phosphore volatils. Une telle structure se prête au contrôle de la croissance, mais nécessite une étape supplémentaire de polissage du substrat 2 jusqu'à obtention de l'épaisseur 2' désirée et exige en outre l'emploi du matériau 2''.

L'invention décrite ci-dessus se rapporte donc également à un procédé de fabrication d'un tel agencement de diodes capables d'émettre chacune une lumière de couleur différente susceptibles de recevoir des connexions électriques réalisées par reflux de soudure et isolées les unes des autres.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter toutes modifications de forme ou de détail qu'il juge utiles, sans pour autant sortir du cadre de ladite invention.

**Revendications**

1. Agencement de diodes luminescentes multicolores intégrées dans un corps semi-conducteur du genre comportant: un substrat (2), une couche épitaxiale semi-conductrice (3) d'un premier type de conductivité qui recouvre le substrat composée par au moins deux éléments semi-conducteurs dont le gradient de concentration varie avec la profondeur, au moins deux régions (6, 7) formées dans cette couche, d'un type de conductivité opposé, dont les jonctions (8, 9) sont disposées à des profondeurs différentes afin qu'elles émettent des lumières de couleur différente, des moyens de polarisation de ces régions, caractérisé en ce que le substrat semi-conducteur est muni d'ouvertures (11, 12) correspondantes aux régions pour permettre à la lumière produite par les jonctions de sortir de la structure.

2. Agencement de diodes luminescentes selon la revendication 1 caractérisé en ce que le substrat est composé par une première couche semi-conductrice (2'), transparente à la lumière, et par une deuxième couche (2") qui est munie d'ouvertures correspondantes aux régions pour permettre à la lumière produite par les jonctions de sortir de la structure.

3. Agencement de diodes luminescentes selon l'une des revendications 1 ou 2 caractérisé en ce que la couche épitaxiale est passivée par une couche diélectrique (10) munie d'ouvertures aux emplacements des régions pour permettre la réalisation de liaisons électriques avec lesdites régions.

4. Agencement de diodes luminescentes selon la revendication 3 caractérisé en ce que ces liaisons électriques sont des contacts (13, 14) susceptibles d'être interconnectés par la technique à reflux de soudure.

5. Agencement de diodes luminescentes selon l'une des revendications ci-dessus caractérisé en ce que le substrat (2) est un substrat semi-conducteur de type binaire et que la couche épitaxiale (3) est du type $A_xB_{1-x}C$ ou $AB_{1-x}C_x$, le coefficient x diminuant entre le substrat et la surface de la couche épitaxiale.

6. Agencement de diodes luminescentes selon la revendication 5 caractérisé en ce que le substrat (2) est du GaAs et la couche épitaxiale (3) du $Al_xGa_{1-x}As$.

7. Agencement de diodes luminescentes selon la revendication 5 caractérisé en ce que le substrat (2) est du GaP et la couche épitaxiale (3) du $GaAs_{1-x}P_x$.

8. Procédé de fabrication d'un agencement de diodes selon la revendication 1, caractérisé en ce qu'il comporte les étapes suivantes: formation d'une couche épitaxiale (3) sur un substrat (2), du même type de conductivité, composée par au moins deux éléments semi-conducteurs dont le gradient de concentration varie avec la profondeur, formation d'au moins deux régions (6, 7) d'un type de conductivité opposé dans la couche épitaxiale, de telle sorte que les jonctions (8, 9) formées entre ces régions et cette couche soient situées à des profondeurs différentes correspondant à des longueurs d'onde d'émission lumineuse différentes, et application de moyens de polarisation de ces régions.

9. Procédé de fabrication selon la revendication 8, caractérisé en ce qu'il comporte en outre l'étape de formation d'une couche diélectrique de passivation (10) de la couche épitaxiale (3).

10. Procédé de fabrication selon la revendication 9 caractérisé en ce qu'il comporte en outre l'étape de formation par décapage d'ouvertures (11, 12) dans le substrat en alignement avec les régions (6, 7), pour permettre l'émission de lumière tout en assurant l'isolation optique entre différentes émissions.

11. Procédé de fabrication selon la revendication 9 caractérisé en ce qu'il comporte en outre les étapes de élimination partielle du substrat (2) jusqu'à atteindre une épaisseur (2') transparente pour l'émission lumineuse, formation d'une nouvelle couche semi-conductrice (2") sur le substrat, et formation par décapage d'ouvertures (11, 12) dans cette nouvelle couche, en alignement avec ces régions (6, 7), pour permettre l'émission de lumière tout en assurant l'isolation optique entre différentes émissions.

12. Procédé de fabrication selon l'une quelconque des revendications 8 à 11 caractérisé en ce que les moyens de polarisation comprennent des contacts métalliques (13, 14) qui débordent de ces régions (6, 7) et autorisent le dépôt de connexions électriques par la technique dite du reflux de soudure.

13. Procédé de fabrication selon l'une quelconque des revendications 8 à 12 caractérisé en ce que le substrat (2) est composé de GaAs et la couche épitaxiale (3) est composée de $Al_xGa_{1-x}As$.

14. Procédé de fabrication selon l'une quelconque des revendications 8 à 12 caractérisé en ce que le substrat (2) est composé de GaP et la couche épitaxiale (3) est composée de $GaAs_{1-x}P_x$.

## Claims

1. A multicolor light emitting diode array integrated into a semiconductor body comprising: a substrate (2), a semiconductor epitaxial layer (3) of a first type of conductivity formed over the substrate and comprising at least two semiconductor elements whose concentration gradient varies with depth, at least two regions (6, 7) of the opposite type of conductivity formed into said layer and whose junctions (8, 9) are made to different depths to emit light of varying colors, means for polarizing said regions, characterized in that the semiconductor substrate is provided with openings (11, 12) corresponding to said regions to permit light produced by the junctions to escape from the structure.

2. A light emitting diode array according to claim 1, characterized in that the substrate comprises a first semiconductor layer (2') transparent to light and a second layer (2") provided with openings corresponding to said regions to permit light produced by the junctions to escape from the structure.

3. A light emitting diode array according to claim 1 or 2, characterized in that the epitaxial layer is passivated by a dielectric layer (10) provided with openings corresponding to said regions to enable electric connections to be made thereto.

4. A light emitting diode array according to claim 3, characterized in that said electric connections are contact pads (13, 14) which may be interconnected using the solder reflow technique.

5. A light emitting diode array according to any one of the preceding claims, characterized in that the substrate (2) is a binary type semiconductor substrate and in that the epitaxial layer (3) is of type $A_xB_{1-x}C$ or $AB_{1-x}C_x$, with the value of the variable x decreasing as one progresses from the substrate towards the surface of the epitaxial layer.

6. A light emitting diode array according to claim 5, characterized in that the substrate (2) is GaAs and the expitaxial layer (3) is $Al_xGa_{1-x}As$.

7. A light emitting diode array according to claim 5, characterized in that the substrate (2) is GaP and the epitaxial layer (3) is $GaAs_{1-x}P_x$.

8. A process of manufacturing a diode array according to claim 1, characterized in that it comprises the steps of: forming an epitaxial layer (3) onto a substrate (2) of the same type of conductivity, said layer being comprised of at least two semiconductor elements whose concentration gradient varies with depth, forming at least two regions (6, 7) of the opposite type of conductivity into the eptiaxial layer, such that the junctions (8, 9) between said regions and said layer are made to different depths corresponding to different light emitting wavelengths, and applying means of polarizing said regions.

9. A manufacturing process according to claim 8, characterized in that it includes the further step of: forming a dielectric layer (10) for passivating the expitaxial layer (3).

10. A manufacturing process according to claim 9, characterized in that it includes the further step of: etching openings (11, 12) out of the substrate in registration with regions (6, 7) to permit light to be emitted while providing optical isolation between different light emissions.

11. A manufacturing process according to claim 9, characterized in that it includes the further steps of: removing portions of the substrate (2) until a thickness (2') such that it will become transparent to light is reached, forming a new semiconductor layer (2'') onto the substrate, and etching openings (11, 12) out of said new layer in registration with said regions (6, 7) to permit light to be emitted while providing optical isolation between different light emissions.

12. A manufacturing process according to any one of claims 8 to 11, characterized in that said polarizing means include metal contact pads (13, 14) which extend beyond said regions (6, 7) and permit electrical connections to be made using the so-called solder reflow technique.

13. A manufacturing process according to any one of claims 8 to 12, characterized in that the substrate (2) is GaAs and the epitaxial layer (3) is $Al_xGa_{1-x}As$.

14. A manufacturing process according to any one of claims 8 to 12, characterized in that the substrate (2) is GaP and the epitaxial layer (3) is $GaAs_{1-x}P_x$.

## Patentansprüche

1. Anordnung von in einem Halbleiterkörper integrierten vielfarbigen Leuchtdioden, bestehend aus einem Substrat (2), einer das Substrat bedeckenden Halbleiter-Epitaxieschicht (3) eines ersten Leitungstyps aus mindestens zwei Halbleiterelementen, deren Konzentrationsgradient von der Tiefe abhängt, mindestens zwei in dieser Schicht gebildeten Bereichen (6, 7) vom entgegengesetzten Leitungstyp, deren Übergänge (8, 9) in verschiedenen Tiefen angeordnet sind, um verschiedenfarbiges Licht zu erzeugen, und Polarisationsmittel für diese Bereiche, dadurch gekennzeichnet, dass das Halbleitersubstrat mit diesen Bereichen entsprechenden Öffnungen (11, 12) versehen ist, durch die das durch die Übergänge erzeugte Licht austritt.

2. Anordnung nach Anspruch 1, dadurch gekennzeichnet, dass das Substrat aus einer ersten lichtdurchlässigen Halbleiterschicht (2') sowie einer zweiten Schicht (2'') besteht, die mit diesen Bereichen entsprechenden Öffnungen versehen ist, durch die das durch die Übergänge erzeugte Licht austritt.

3. Anordnung nach Anspruch 1 oder 2, dadurch gekennzeichnet, dass die Epitaxieschicht durch eine mit den Bereichen entsprechenden Öffnungen versehenen dielektrischen Schicht (10) passiviert ist, über die die elektrische Verbindung mit diesen Bereichen hergestellt wird.

4. Anordnung nach Anspruch 3, dadurch gekennzeichnet, dass die elektrischen Verbindungen aus Kontakten (13, 14) bestehen, die mit Hilfe der Aufschmelzlöttechnik untereinander verbunden werden können.

5. Anordnung nach einem der Ansprüche 1 bis 4, dadurch gekennzeichnet, dass das Substrat (2) aus einem binären Halbleitersubstrat und die Epitaxieschicht (3) aus $A_xB_{1-x}C$ oder $AB_{1-x}C_x$ besteht, wobei der Wert der Variablen x vom Substrat bis zur Oberfläche der Epitaxieschicht fortschreitend kleiner wird.

6. Anordnung nach Anspruch 5, dadurch gekennzeichnet, dass das Substrat (2) aus GaAs und die Epitaxieschicht (3) aus $Al_xGa_{1-x}As$ besteht.

7. Anordnung nach Anspruch 5, dadurch gekennzeichnet, dass das Substrat (2) aus GaP und die Epitaxieschicht (3) aus $GaAs_{1-x}P_x$ besteht.

8. Herstellungsverfahren für eine Anordnung nach Anspruch 1, gekennzeichnet durch folgende Verfahrensschritte: Bildung einer Epitaxieschicht (3) auf einem Substrat (2) desselben Leitungstyps, wobei diese aus mindestens zwei Halbleiterelementen besteht, deren Konzentrationsgradient von der Tiefe abhängt, Bildung von mindestens zwei Bereichen (6, 7) vom entgegengesetzten Leitungstyp in der Epitaxieschicht, in der Weise, dass die zwischen diesen Bereichen und dieser Schicht gebildeten Übergänge (8, 9) in verschiedenen, unterschiedliche Licht-Wellenlängen liefernden Tiefen liegen und Anwendung von Polarisationsmitteln für diese Bereiche.

9. Herstellungsverfahren nach Anspruch 8, gekennzeichnet durch folgenden zusätzlichen Verfahrensschritt: Bildung einer dielektrischen Schicht (10) zum Passivieren der Epitaxieschicht (3).

10. Herstellungsverfahren nach Anspruch 9, gekennzeichnet durch folgenden zusätzlichen Verfahrensschritt: Ätzen von auf die Bereiche (6, 7) ausgerichteten Öffnungen (11, 12) in das Substrat, durch die der Lichtaustritt und gleichzeitig die optische Trennung der einzelnen Austrittsstellen gewährleistet wird.

11. Herstellungsverfahren nach Anspruch 9, gekennzeichnet durch folgende zusätzliche Verfahrensschritte: Teilweises Abtragen des Substrats (2) bis auf eine lichtdurchlässige Dicke (2'), Bildung einer neuen Halbleiterschicht (2'') auf dem Substrat, und Ätzen von auf die Bereiche (6, 7) ausgerichteten Öffnungen (11, 12) in diese neue Schicht, wodurch der Lichtaustritt und gleichzeitig die optische Trennung der einzelnen Austrittsstellen gewährleistet wird.

12. Herstellungsverfahren nach einem der Ansprüche 8 bis 11, dadurch gekennzeichnet, dass die Polarisationsmittel Metallkontakte (13, 14) einschliessen, die über diese Bereiche (6, 7) hinausragen und dadurch das Niederschlagen von elektrischen Verbindungen mit Hilfe der sog. Aufschmelzlöttechnik ermöglichen.

13. Herstellungsverfahren nach einem der Ansprüche 8 bis 12, dadurch gekennzeichnet, dass das Substrat (2) aus GaAs und die Epitaxieschicht (3) aus $Al_xGa_{1-x}As$ besteht.

14. Herstellungsverfahren nach einem der Ansprüche 8 bis 12, dadurch gekennzeichnet, dass das Substrat (2) aus GaP und die Epitaxieschicht (3) aus $GaAs_{1-x}P_x$ besteht.

FIG. 1

$AB_{1-x}C_x$    OU    $A_xB_{1-x}C$

10    6    8    9    P    7    10

5    P    3

N

4    N    2

DIMINUE

1

FIG. 2

ORANGE                    ROUGE

11                        12

2    4

N

3    P    X = 0,5    P    X = 0,3

10    8    5    9    10

6    7

1    13    14

FIG. 3

11    ORANGE                    ROUGE    12

2"

2'

4    N

3

10    8    6    13    9    7    14    10

7